# EUROPEAN PATENT APPLICATION

(11) **EP 4 835 126 A1**
(43) Date of publication of application: **04.11.2026**
(21) Application number: 25305601.4
(22) Date of filing: 28.04.2025
(51) Int. Cl.: C23C 14/06, C23C 14/22, G02B 1/11

(54) **OPTICAL ARTICLE HAVING AN ANTIREFLECTIVE COATING WITH SUPERIOR ABRASION AND HEAT RESISTANCE**

(71) Applicant: ESSILOR INTERNATIONAL, 94220 Charenton-Le-Pont (FR)
(72) Inventor: MAITRE, Nicolas, 78700 CONFLANS-SAINTE-HONORINE (FR); THEODEN, Alexis, 94220 CHARENTON-LE-PONT (FR)
(74) Representative: Jacobacci & Partners France

(57) **Abstract**

The invention relates to an optical article having a front main face and a rear main face, comprising: at least one base element having a front main surface and a rear main surface, and at least one multilayer antireflective coating, deposited on said front main surface and/or said rear main surface of the base element, which comprises at least one layer having a low refractive index which is lower than 1.55, defined as "LI layer", and at least one layer having a high refractive index which is equal to or higher than 1.55, defined as "HI layer", characterized in that said at least HI layer comprising silicon nitride (Si₃N₄) has been deposited by vacuum evaporation of a silicium raw material using electron gun with ion assistance deposition (IAD) including ion gun under nitrogen gas so as to obtain an optical article exhibiting improved optical characteristics, while having excellent mechanical properties.

The invention also relates to a method of manufacturing such optical article and to an eyewear comprising an optical article.

## Description

### TECHNICAL FIELD OF THE INVENTION

The invention relates to an optical article, which is in general an ophthalmic lens, in particular a spectacle lens, comprising a base element, such as a substrate, having a front main face and a rear main face, the front main face and/or the rear main face being coated with a multilayer interferential coating. Especially, the multilayer interferential coating is able to and/or configured to reduce reflection at least in the visible region, while exhibiting both superior abrasion and heat resistance.

The invention also relates to a method for manufacturing such optical article.

In addition, the invention deals with an eyewear comprising the optical article defined above and a holding structure configured to hold the at least optical article facing a wearer's eye.

### BACKGROUND INFORMATION AND PRIOR ART

An antireflection coating usually consists of a multilayer comprising antireflective thin layers, generally an alternation of layers based on a dielectric material of high refractive index and a dielectric material of low refractive index. When deposited on a transparent substrate, the function of such a coating is to reduce its light reflection and therefore to increase its light transmission. A substrate thus coated will therefore have its transmitted light/reflected light ratio increased, thereby improving the visibility of objects placed behind it. When it is sought to achieve a maximum antireflection effect, it is then preferable to provide both faces (front and rear faces) of the substrate with this type of coating.

This antireflective coating is usually used in the ophthalmic field. Accordingly, traditional antireflective coatings are designed and optimized to reduce reflection on the lens surface in the visible region, typically within the spectrum range of from 380 nm to 780 nm. In general, the mean light reflection factor in the visible region Rv on the front and/or rear faces of an ophthalmic lens is between 1.5 to 2.5%.

Some of these antireflective coatings may also be designed and optimized to reduce reflection on the lens surface within the UVA band of from 315 to 400 nm and/or the UVB band of from 280 to 315 nm. These UVA and UVB bands are indeed particularly harmful to the retina. The mean reflection in the UVA and UVB regions may thus attain high levels (up to 60%) for traditional antireflective lenses. In one hand, as regards non-solar antireflective articles which are marketed by most of the manufacturers over the course of these recent years, the UV mean reflection does range from 10 to 25%, for an angle of incidence of from 30 to 45°. It is not problematic on the front face of the lens, since the major part of the UV radiation which comes from the front of the wearer and might attain the wearer's eye (normal incidence, 0 to 15°) generally gets absorbed by the ophthalmic lens substrate. A better protection against UV radiation transmission may be obtained through solar ophthalmic lenses, which are studied and designed to reduce the visible spectrum luminosity, totally absorb UVB and totally or partially absorb UVA. On the other hand, the UV radiation resulting from light sources located behind the wearer may reflect on the lens rear face and reach the wearer's eye if the lens is not provided with an antireflective coating which is efficient in the ultraviolet region, thus potentially affecting the wearer's health. Such phenomenon is made stronger by the trend for fashion sunglasses with high diameters which increase the risk of stray reflections getting into the eyes. It is admitted that the light rays that may reflect onto the lens rear face and reach the wearer's eye have a narrow incidence angle range, ranging from 30° to 45° (oblique incidence).

Structure of interferential coatings, such as antireflective coating, is becoming more and more complex to make them more robust and more resistant to real life.

Several solutions have been developed in the prior art. A first solution consists in depositing on the top of the antireflective coating, a thick outermost layer made of SiO₂. This solution does not allow to reach good antireflective efficiency. Rv values are usually higher than 1%, which is not compliant with quality standards for premium antireflective optical articles in the ophthalmic field. Another solution consists in depositing, between a hardcoat layer and the antireflective coating, a thick SiO₂ layer. This solution is traditionally used in ophthalmic industry. However, it can generate thermal and mechanical crazing weakness because of the high thickness of the antireflective stack. Moreover, it increases process cycle time in production. Another solution consists in selecting the thicknesses of the different layers of the antireflective coating having a low refractive index which is lower than 1.55, defined as "LI layer" and having a high refractive index which is equal to or higher than 1.55, defined as "HI layer", so that to use a high low index/high index ratio. However, as for the previous solution, it can reduce the optical performances of the optical article.

Thus, the type of oxides, the number of layers and the total thickness of the antireflecting coating is continuously increasing to reach suitable balance between high level of abrasion resistance and optical performances. This complexity forces the industrials to make a compromise between antireflecting efficiency and thermo-mechanical performances, in particular regarding thermal or mechanical crazing resistance.

Moreover, it becomes also more and more difficult to produce and control the structure of these antireflecting coatings in production.

Indeed, the optimization of the optical and colorimetric characteristics of the optical article must not be also detrimental to its robustness. The term "robustness" of an optical article, such as an ophthalmic lens, in the present invention is defined as the ability of this optical article to maintain stable properties despite the variations induced by its manufacturing process. These variations depend, for instance, on the type of substrate which is used, the setting of the manufacturing machine (e.g. temperature schedule, appropriate time, humidity percentage, vacuum level in the antireflective equipment, cycle time, ...) and/or its usage mode, the replacement of said manufacturing machine by another one.

Indeed, when multilayered interferential coatings are manufactured at industrial scale, some thickness variations for each layer generally occur. These variations lead to different reflection performance, and especially different perceived residual reflected color of the multilayered interferential coating. If the perceived residual reflected color of the interferential coating of two lenses is different, these lenses will appear different and will not be able to be associated in pair. Furthermore, depending on the curvatures of the lenses and the value of incidence (angle θ), the residual reflected color of the multilayered interferential coating of each lens may not appear homogeneous in color on all the surface of the lens ("chameleon effect"). A different residual reflected color between the right and the left portions of a lens, such as a color gradient of different hues "h" (not the same color turning for instance from blue to red) or a color gradient of different color intensity (for example, turning from saturated color to a less saturated color, or inversely) may be viewed by an observer according to the incidence angle θ.

Finally, sourcing of high index materials which are used in standard antireflecting coatings, such as ZrO₂, Ta₂O₅, is not sustainable.

Therefore, an object of the current invention is thus to propose a new optical article which avoids, at least in part, the aforementioned drawbacks.

In particular, it would be desirable to provide novel interferential coatings, such as antireflective coatings, having very good antireflective properties at least in the visible region and possibly in the UVA and UVB bands, while having an excellent mechanical resistance, such as exhibiting high abrasion and heat resistance and preferably robustness properties.

Especially, there is a need to provide such novel interferential coatings without compromising the economic and/or industrial feasibility of its manufacture. Indeed, the challenge is therefore to propose a simple and sustainable antireflecting coating with high abrasion resistance, without degrading thermo-mechanical performances.

### SUMMARY OF THE INVENTION

The Applicant sought to develop a new optical article having a low reflectivity on its front face and/or rear main face, while having excellent mechanical properties and this without compromising preferably not only the robustness performances of the optical article, but also its ease of implement in production, thus guaranteeing a good productivity. Preferably, the optical article has been developed for the ophthalmic field and overcomes especially the constraints related to this technical field.

For that purpose, the invention refers to an optical article having a front main face and a rear main face comprising:
one base element having a front main surface and a rear main surface,
at least one interferential multilayered coating deposited on the front main surface and/or on the rear main surface of the base element comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
characterized in that said at least one HI layer comprising silicon nitride (Si₃N₄) has been deposited by vacuum evaporation of a silicium raw material using electron gun with ion assistance deposition (IAD) including ion gun under nitrogen gas so as to obtain an optical article exhibiting
   * an abrasion resistance, measured according to the SRT test as defined in paragraph "Detailed description, A°) Definition" below, which is lower than or equal to 2.0, and
   * a critical temperature which is higher than or equal to 75°C.

Preferably, the total physical thickness of the at least one interferential coating is equal to or lower than 270 nm.

The Applicant has found that the specific deposition of at least one HI layer comprising silicon nitride (Si₃N₄) by vacuum evaporation of a silicium raw material using electron gun with ion assistance deposition (IAD) including ion gun under nitrogen gas enables to increase the mechanical resistance of the obtained optical article having a relatively thin interferential coating, while having an increased yield especially as compared to a deposition made by another techniques, such as sputtering. For instance, an antireflective stack containing Si₃N₄ and SiO₂ can be deposited by sputtering (or magnetron sputtering). However, the known yields will be much lower. Indeed, it is possible to put 90 substrates of Orma^{®} -2.00 in an evaporation machine, such as a BAK 760 device, while a sputtering machine, such as SP200 of Satisloh can receive only 4 substrates. In addition, the Applicant has also found that as compared to other technologies, the claimed invention enables to provide an optical article having an excellent mechanical resistance with few layers in the stack of the interferential layer, i.e.: in general lower than or equal to 6 so as to obtain an interferential coating having in general a total physical thickness equal to or lower than 270 nm. For instance, antireflective coatings comprising tantalum pentoxide (Ta₂O₅), also deposited by vacuum evaporation, are considered to be highly abrasion resistant. However, it is more complex than simple stacking with Si₃N₄. Indeed, in general, tantalum pentoxide-based stack is composed of at least nine layers (anti-fouling treatment excluded) and is deposited in 39 minutes on a BAK760 device. The simple stacking with Si₃N₄ according to the invention is composed preferably of only five layers (dirt treatment excluded) and is deposited in 28 minutes. That is eleven minutes less process time for equivalent mechanical and thermo-mechanical properties (critical temperature and abrasion resistance).

Hence, and as it will be described hereafter, it has been found that Si₃N₄ allows to create thin optical structure with less layers. As the complexity and thickness of optical structures are reduced, this allows to have a shorter process with less impact on machine soiling.

The invention also deals with a method for manufacturing an optical article, comprising the following step:
- providing a base element having a front main surface and a rear main surface;
- applying by vacuum evaporation on said rear main face and/or on said front main face, at least one interferential multilayered coating comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
characterized in that said at least one HI layer comprising silicon nitride (Si₃N₄) has been deposited by vacuum evaporation of a silicium raw material using electron gun with ion assistance deposition (IAD) including an ion gun under nitrogen gas.

The method according to the invention enables to obtain an optical article exhibiting:
* an abrasion resistance, measured according to the SRT test as defined in paragraph "detailed description, A°) Definition", which is lower than or equal to 2.0,
* a critical temperature which is higher than or equal to 75°C, and
* preferably an optical index, n, higher than or equal to 1.9 at 550 nm for a absorption coefficient, k, equal to or lower than 2.5*10⁻³ for any wavelengths in the visible region ranging from 380 to 780 nm.

Especially, the Applicant has found that thanks to the ion assistance deposition (IAD) and in general also the evaporation rate parameters of the raw materials, it is possible to refine the optical index (n) and absorption (k), as well as the mechanical properties (i.e.: high abrasion resistance and high heat resistance).

The invention also relates to an eyewear comprising an optical article, especially such as defined above or obtained according to the method as defined above and preferably a holding structure configured to hold the at least optical article facing a wearer's eye; in general the optical article is an optical lens, especially an ophthalmic lens.

### BRIEF DESCRIPTION OF THE DRAWING

For a more complete understanding of the description provided herein and the advantages thereof, reference is now made to the brief description below, taken in connection with the accompanying drawing and detailed description, wherein like reference numerals represent like parts.

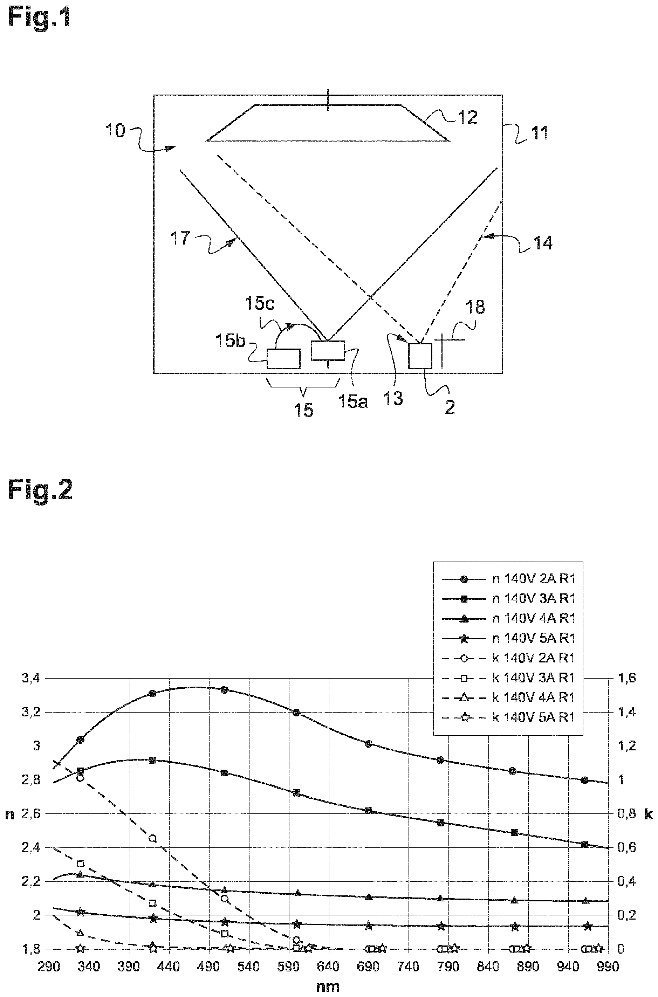

FIG. 1 shows a material deposition device according to one implementation variant that is suitable for manufacturing the optical article according to the invention or for performing the method according to the invention;
FIG. 2 shows the evolution of the optical index (i.e.: the refractive index, n, and the absorption coefficient, k) of the obtained silicon nitride layer as function of the wavelengths (nm) by varying the anode current of the ion gun included in the material deposition device (the anode voltage is fixed at 140 V and the evaporation rate R1 is fixed at 1 nm/s);

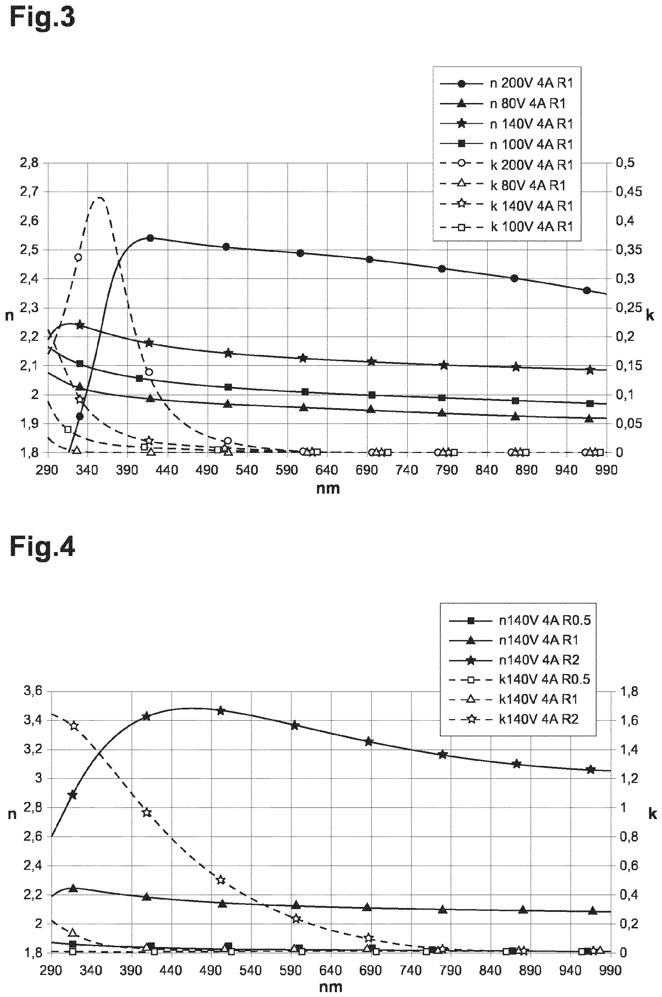

FIG.3 shows the evolution of the optical index (i.e.: the refractive index, n, and the absorption coefficient, k) of the obtained silicon nitride layer as function of the wavelengths (nm) by varying the anode voltage of the ion gun included in the material deposition device (the anode current discharge is fixed at 4 A and the evaporation rate R1 is fixed at 1 nm/s);
FIG.4 shows the evolution of the optical index (i.e.: the refractive index, n, and the absorption coefficient, k) of the obtained silicon nitride layer as function of the wavelengths (nm) by varying the evaporation speed of the Si raw material (corresponding also to the deposition speed of the silicon nitride layer) (the anode voltage is fixed at 140 V and the anode current discharge is fixed at 4 A);

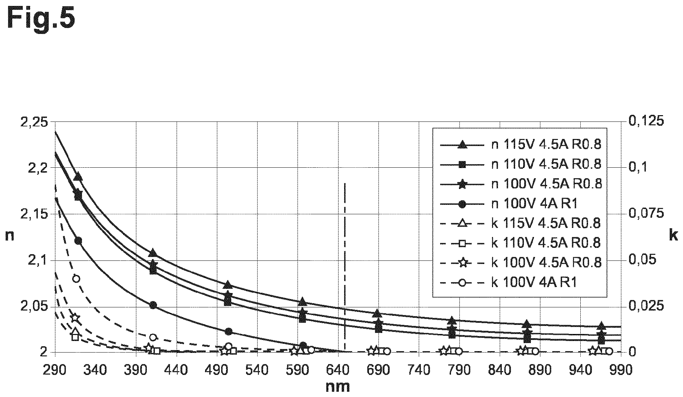

FIG.5 shows the evolution of the optical index (i.e.: the refractive index, n, and the absorption coefficient, k) of the obtained silicon nitride layer as function of the wavelengths (nm) by varying the evaporation speed of the Si raw material and of the anode voltage (the anode current discharge is fixed at 4.5 A).

### DETAILED DESCRIPTION OF THE INVENTION

### A) Definitions

The terms "comprise" (and any grammatical variation thereof, such as "comprises" and "comprising"), "have" (and any grammatical variation thereof, such as "has" and "having"), "contain" (and any grammatical variation thereof, such as "contains" and "containing"), and "include" (and any grammatical variation thereof, such as "includes" and "including") are openended linking verbs. They are used to specify the presence of stated features, integers, steps or components or groups thereof, but do not preclude the presence or addition of one or more other features, integers, steps or components or groups thereof. As a result, a method, or a step in a method, that "comprises," "has," "contains," or "includes" one or more steps or elements possesses those one or more steps or elements, but is not limited to possessing only those one or more steps or elements.

Unless otherwise indicated, all numbers or expressions referring to quantities of ingredients, ranges, reaction conditions, etc. used herein are to be understood as modified in all instances by the term "about."

Also, unless otherwise indicated, the indication of an interval of values « from X to Y » or "between X to Y", according to the present invention, means as including the values of X and Y.

We mean an ophthalmic article defined by, but not exclusive of corrective lenses, non-corrective lenses, contact lenses, intra-ocular lenses, magnifying lenses, protective lenses, and visors containing photochromic compounds within a coating, the lens material, a film, or any adjacent layer.

As used herein, "a base element" can consist in an optical substrate, such as an ophthalmic substrate or in a support film of optical quality to be fixed on an optical/ophthalmic substrate thanks to an adhesive such as a pressure-sensitive adhesive of optical quality (PSA layer) (i.e.: laminate).

As used herein, "interferential coating", such as "anti reflective coating" means a coating, generally composed of antireflective thin layers and comprises at least one layer having a low refractive index which is lower than 1.55, defined as "LI layer", and at least one layer having a high refractive index which is equal to or higher than 1.55, defined as "HI layer.

In the present application, when an optical lens comprises one or more coatings onto the surface thereof, the expression "to deposit a layer, a sheet or a coating onto the article" is intended to mean that a layer, a sheet or a coating is deposited onto the external (exposed) surface of the outer coating of the article, that is to say its coating that is the most distant from the substrate.

Unless otherwise indicated, a coating, a layer or a sheet, that is said to be "on" a substrate/base element or deposited "onto" a substrate/base element, is defined as a coating, a layer or a sheet, which (i) is positioned above the substrate/base element, (ii) is not necessarily in contact with the substrate/base element, that is to say one or more intermediate coatings/sheets may be arranged between the substrate/base element and the coating or sheet in question, and (iii) does not necessarily completely cover the substrate/base element.

In a preferred embodiment, the coating on a substrate/base element or deposited onto a substrate/base element is in direct contact with this substrate.

When "a layer/sheet 1 is lying under a layer 2/sheet 2", it is intended to mean that layer/sheet 2 is more distant from the substrate than layer 1/sheet 1 respectively.

By outermost layer or sheet of the interferential coating or of the antireflective coating, it is meant the layer or sheet of the interferential coating or of the antireflective coating which is the furthest from the substrate.

By innermost layer or sheet of the interferential coating or of the antireflective coating, it is meant the layer or sheet of the interferential coating or of the antireflective coating which is the closest to the substrate.

By inner layer/sheet of the interferential coating or of the antireflective coating, it is meant any layer/sheet of the interferential coating or of the antireflective coating except for the outermost layer/sheet of said antireflective coating.

Also, unless stated otherwise, all thicknesses disclosed in the present application relate to physical thicknesses.

As used herein, a layer of the interferential coating or of the antireflective coating is defined as having a thickness higher than or equal to 1 nm. Thus, any layer having a thickness lower than 1 nm will not be considered when counting the number of layers in the interferential coating. A sub-layer (having generally a physical thickness of 150 nm) is also not considered when counting the number of layers of the interferential or of the antireflective coating.

Unless otherwise specified, the refractive indexes referred to in the present application are expressed at 25 °C at a wavelength of 550 nm.

As used herein, the rear (or the inner or Concave or CC) surface of the base element/substrate is intended to mean the surface which, when using the article, is the nearest from the wearer's eye. It is generally a concave surface. On the contrary, the front surface of the substrate/base element (or Convex or CX), is the surface which, when using the article, is the most distant from the wearer's eye. It is generally a convex surface.

Also, as used herein, a "transparent substrate/base element" is understood to be transparent, when the observation of an image through said substrate is perceived with no significant loss of contrast, that is, when the formation of an image through said substrate is obtained without adversely affecting the quality of the image.

The optical characteristics comprise at least the mean light reflection factor in the visible region Rᵥ , also named the "luminous reflectance".

Herein, the "luminous reflectance" noted Rᵥ, should be understood as defined in the ISO 13666:1998 standard, and measured in accordance with the ISO 8980-4:2006. It is defined in the wavelength range of from 380 to 780 nm. Rᵥ is usually measured for an angle of incidence lower than 17°, typically of 15°, but can be evaluated for any angle of incidence.

The mean light reflection factor Rᵥ may be defined by the following equation: ${R}_{V} = \frac{{\int }_{380}^{780} R \left(λ\right) ⋅ V \left(λ\right) ⋅ {D}_{65} \left(λ\right) ⋅ dλ}{{\int }_{380}^{780} V \left(λ\right) ⋅ {D}_{65} \left(λ\right) ⋅ dλ}$ where R(λ) is the reflectance at a wavelength λ, V(λ) is the eye sensitivity function in the color space defined by the CIE (Commission on Illumination, in French "Commission Internationale de I'Eclairage") in 1931 and D65(λ) is the daylight illuminant defined in the CIE S005/E-1998 standard. The illuminant can be adapted according to the light situation. For instance, a derived Rᵥ function may be defined for indoor light situations using LED illuminant rather than the usual D65.

According to the invention, when the mean light reflection factor in the visible region Rᵥ onto the front and/or rear main face of the optical article is equal to or lower than 2.5%, this means that the multilayered antireflective coating is able to provide an antireflective behaviour onto the front and/or rear main face of the optical article respectively.

According to the invention, when the mean light reflection factor in the visible region Rᵥ onto the front and/or rear main face(s) of the optical article is strictly higher than 2.5%, more preferably higher than 3%, even more preferably higher than 5%, this means that the multilayered interferential coating is able to provide a mirror behaviour onto the front or rear main face of the optical article respectively.

As used herein, the factor T_{V} should be understood as defined by the international normalized definition (ISO 13666:1998 Standard) and is measured in accordance with the ISO 8980-3 Standard. It is defined in the wavelength range of from 380 to 780 nm.

The optical characteristics may also comprise at least a mean reflection factor in the UV bands: UVA band ranges from 315 to 380nm and/or the UVB band ranges from 280 to 315 nm. These UVA and UVB bands are indeed particularly harmful to the retina. The mean reflection in the UVA and UVB regions may thus attain high levels (up to 60%) for traditional antireflective lenses.

According to the invention, a mean reflection factor R_{UV} is defined through the following relation: ${R}_{UV} = \frac{{\int }_{280}^{380} W \left(λ\right) . R \left(λ\right) . dλ}{{\int }_{280}^{380} W \left(λ\right) . dλ}$ wherein R(λ) represents the optical article spectral reflection factor at a given wavelength, and W(λ) represents a weighting function equal to the product of the solar spectrum irradiance Es(λ) and the efficiency relative spectral function S(λ).

The spectral function W(λ), enabling to calculate the ultraviolet radiation transmission factors, is defined according to the ISO 13666:1998 standard. It makes it possible to express the ultraviolet solar radiation distribution tempered by the relative spectral efficiency of such radiation for a user, since it simultaneously takes both the solar spectral energy Es(λ) into account, which does globally emit less UVB-rays as compared to UVA-rays, and the spectral efficiency S(λ), UVB-rays being more harmful than UVA-rays. The values for those three functions in the ultraviolet region are given in the table disclosed in ISO 13666:1998 standard (which is reproduced at page 6 of the publication WO 2012/076714).

In general, the mean reflection factor Rᵤᵥ is measured in the present application at an angle of incidence of 35°.

In the context of the invention, the E-SPF ("Eye Sun Protection Factor") of an optical article is given by the following relationship: $E - SPF = 100 % / \left({Ruv}^{35 °}\left(%\right)+3σ{Ruv}^{35 °}\left(%\right)\right)$ where
Ruv^{35°} is the amount of UV (between 280 nm and 380 nm) reflected at an angle of incidence of 35° from the back face,
3σRuv^{35°}(%) is 3 times the value of the robustness of Ruv³⁵.

The colorimetric coefficients of the optical article of the invention in the international colorimetric system CIE L*a*b* (1976) (such as the Chroma C* and the hue "h") are calculated between 380 and 780 nm and the observer into account (angle of 10°) and under the standard Illuminant D65. The observer is a "standard observer" as defined in the international colorimetric system CIE L*a*b*. Indeed, in the CIE L*a*b* space, it is possible to express not only overall variations in color, but also in relation to one or more of the parameters L*, a* and b*. This can be used to define new parameters and to relate them to the attributes of the visual sensation. Clarity, related to luminosity, is directly represented by the value of L*. Chroma: ${C}^{∗} = \sqrt{\left({a}^{∗ 2}+{b}^{∗ 2}\right)}$ defines the chromaticness. The angle of hue: *h* = tan⁻¹(*b** / *a**) (expressed in degrees) relates to the hue.

According to the invention, the colorimetric measurements (in reflection) of the at least one face coated with the antireflective multilayered coating of the invention: reflection factors Rᵥ, hue angle h, and chroma C* in the international colorimetric CIE (L*, a*, b*) space were carried out with a Zeiss spectrophotometer under the standard illuminant and the standard observer 10° (for h and C*). The usual range for angle of incidence is from 0° to 75° and is typically 15° and 45° for the present invention.

According to the invention, the "angle of incidence (symbol θ)" is the angle formed by a ray light incident on an ophthalmic lens surface and a normal to the surface at the point of incidence. The ray light is for instance an illuminant light source, such as the standard illuminant D65 as defined in the international colorimetric CIE L*a*b* (1976). Generally, the angle of incidence changes from 0° (normal incidence) to 90° (grazing incidence).

As used herein, the critical temperature of an optical article is defined as being the temperature starting from which cracks appear in a coating present at the surface of the substrate (on either main face), which results in degradation of the coating, generally the interferential coating. The critical temperature of the article was measured in the manner indicated in patent application WO 2008/001011. It was measured one month after production of the optical article.

According to the invention, abrasion resistance is determined with the SRT test (Scratch Resistance Test), in which the evaluated lens and a reference lens (uncoated Orma^{®} lens) are simultaneously abraded using a moving material with a given mass and size grading. The evaluation of the test is carried out by measuring the evolution of the haze of the lens after abrasion and comparing the value obtained (ΔH test) with that obtained on the reference lens (ΔHref). Haze was determined as disclosed in WO 2012/173596 without replacing sand by alumina. The result of the test is the normalized haze value (ΔHtest nor corresponding to the normalized diffusion value), which should be as low as possible. The normalized haze value is defined hereafter:
- **Haze normalized (ΔH test nor ):**
- $Δ H test nor \left(%\right) = \frac{Δ H test cor . Δ H ref 0}{Δ H ref}$ Hypothesis: ΔH ref0 = 13% (nominal value on Haze difference after abrasion) With
- ΔH ref : Haze value difference on reference lens
- $Δ H ref = Href - Href initial$
- H ref initial : Haze value on reference lens before abrasion
- H ref : Haze value on reference lens after abrasion
- ΔH test : Haze value difference on test lens
- $Δ H test = Htest - Htest initial$
- H test initial : Haze value on test lens before abrasion
- H test Haze value on test lens after abrasion
   And
- ΔH test cor : Corrective Haze difference value on test lens
- $Δ H test cor = Δ H test \left(0.6374+0.0575 f+0.0377 {f}^{2}\right)$
- With f the sag (mm) of the lens measured on 40 mm diameter

The lower the SRT value is, the better the abrasion resistance. A lens with a SRT value (normalized haze value) of less than 1.5 is a good level (corresponding to mineral glass). A SRT value higher than 3.5 corresponds to an interferential (especially antireflective) lens with a poor abrasion resistance. An improvement of SRT value of 0.2 is quite significant, especially when the SRT value is lower than 2. The test has been carried out one week after production of the article.

Also, the abrasion resistance may also be determined as disclosed in WO 2012/173596. Specifically, abrasion resistance may be measured by means of the sand Bayer test. According to the invention, Bayer abrasion resistance is determined by measuring the percent haze of a coated and uncoated lens, before and after testing on an oscillating sand abrader as in ASTM F 735-81 The abrader is oscillated for 300 cycles with approximately 500 g of aluminum oxide (Al2O3) ZF 152412 supplied by Specialty Ceramic Grains (former Norton Materials), New Bond Street, PO Box 15137 Worcester, Mass. 01615-00137. The haze is measured using a Pacific Scientific Hazemeter model XL-211. The ratio of the uncoated lens haze (final-initial) is a measure of the performance of the coating, with a higher ratio meaning a higher abrasion resistance. The test has been carried out one week after production of the article.

In general, the SRT test and the sand Bayer test are carried out on the front main face of the optical article (generally the Cx main face), that is to say the interferential coating intended to be on the Cc main face are placed on the Cx main face so as to perform the tests.

### B) Optical article according to the invention

As mentioned-above, the Applicant has developed a transparent optical article, especially an ophthalmic lens such as a spectacle lens, comprising a base element, such as a substrate in mineral or organic glass comprising at least a thin and simple interferential multilayered coating which has excellent antireflective properties, and to do so without compromising not only the mechanical performances of the optical article, its robustness, but also the economic and/or industrial feasibility of its manufacture.

The optical article is such as defined in the set of claims and comprises:
one base element having a front main surface and a rear main surface,
at least one interferential multilayered coating deposited on the front main surface and/or on the rear main surface of the base element comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
characterized in that said at least one HI layer comprising silicon nitride (Si₃N₄) has been deposited by vacuum evaporation of a silicium raw material using electron gun with ion assistance deposition (IAD) including ion gun under nitrogen gas so as to obtain an optical article exhibiting:
   * an abrasion resistance, measured according to the SRT test defined in the ASTM F735-81 standard which is lower than or equal to 2.0, and
   * a critical temperature which is higher than or equal to 75°C.

Preferably, the total physical thickness of the at least one interferential coating is thin and is equal to or lower than 270 nm.

The structure of the base element will be described hereafter.

### B.1) The base element/substrate

As mentioned above, the optical article comprises a base element having a front main surface and a rear main surface and at least one interferential multilayered coating deposited onto the front main surface and/or the rear main surface of said base element.

According to one embodiment, this base element can be a laminate, that is to say a support film of optical quality to be fixed on an optical/ophthalmic substrate thanks to an adhesive such as a pressure-sensitive adhesive of optical quality (PSA layer). Preferably, the support film is made of cellulose triacetate (TAC) and has a thickness of at least 40 microns, preferably a thickness in the range of 40 µm to 300 µm inclusive and preferably a thickness of 80 to 190 µm. Materials of the support film may be selected from the group of films made of cellulose triacetate (TAC), cellulose acetate butyrate (CAB), polycarbonate (PC), poly(ethylene terephthalate) (PET), poly(methylmethacrylate) (PMMA), urethane polymer (TPU), cyclo olefin copolymer (COC), polyester copoblock amide (like Pebax) and Polyimides.

According to another embodiment (described hereafter), the base element can consist in an ophthalmic substrate of a transparent optical article, such as a lens or lens blank, and more preferably an ophthalmic lens or lens blank.

Generally speaking, the interferential coating of the optical article according to the invention may be deposited onto any substrate, and preferably onto organic lens substrates, for example a thermoplastic or thermosetting plastic material.

Thermoplastic may be selected from, for instance: polyamides; polyimide; polysulfones; polycarbonates and copolymers thereof; poly(ethylene terephthalate) and polymethylmethacrylate (PMMA).

Thermoset materials may be selected from, for instance: cycloolefin copolymers such as ethylene/norbornene or ethylene/cyclopentadiene copolymers ; homo- and copolymers of allyl carbonates of linear or branched aliphatic or aromatic polyols, such as homopolymers of diethylene glycol bis(allyl carbonate) (CR 39^{®}) ; homo- and copolymers of (meth)acrylic acid and esters thereof, which may be derived from bisphenol A ; polymer and copolymer of thio(meth)acrylic acid and esters thereof, polymer and copolymer of allyl esters which may be derived from Bisphenol A or phthalic acids and allyl aromatics such as styrene, polymer and copolymer of urethane and thiourethane, polymer and copolymer of epoxy, and polymer and copolymer of sulphide, disulfide and episulfide, and combinations thereof.

As used herein, a (co)polymer is intended to mean a copolymer or a polymer. As used herein, a (meth)acrylate is intended to mean an acrylate or a methacrylate. As used herein, a polycarbonate (PC) is intended to mean either homopolycarbonates or copolycarbonates and block copolycarbonates.

Homopolymers of diethylene glycol bis(allyl carbonate) (CR 39^{®}), allylic and (meth)acrylic copolymers, having a refractive index between 1.54 and 1.58, polymer and copolymer of thiourethane, polycarbonates are preferred.

In particular, the base element recommended for the invention is a substrate selected from materials obtained by (co)polymerization of di(ethylene glycol) bis(allyl carbonate) and may correspond to the CR-39^{®} ESSILOR ORMA^{®} lenses.

As it will be shown hereafter, the substrate/base element may be coated with one or more functional coatings prior to depositing the antireflective coating of the invention. These functional coatings traditionally used in optics may be, without limitation, an impact-resistant primer layer, an abrasion-resistant coating and/or a scratch-resistant coating, a polarizing coating, a photochromic coating or a tinted coating. In the following a substrate means either a bare substrate or such a coated substrate.

Preferably, the substrate/base element and the optional abrasion-resistant coating and/or a scratch-resistant coating generally coated onto said substrate have a similar/close refractive index so as to avoid fringes or cosmetic defects.

Prior to depositing the interferential coating, the surface of said substrate is usually submitted to a physical or chemical surface activating treatment, so as to reinforce the adhesion of the antireflective coating. Such pre-treatment is generally conducted under vacuum. It may be a bombardment with energetic and/or reactive species, for example with an ion beam ("Ion PreCleaning" or "IPC") or with an electron beam, a corona discharge treatment, an ion spallation treatment, an ultraviolet treatment or a plasma-mediated treatment under vacuum, generally using an oxygen or an argon plasma. It may also be an acid or basic treatment and/or a solvent-based treatment (water, hydrogen peroxide or any organic solvent).

### B.2) The multilayered interferential coating

As previously mentioned, the optical article according to the invention comprises at least one specific multilayer interferential coating, especially an antireflective coating (named hereafter AR coating), deposited on the main surface and/or the rear main surface of the base element, which comprises at least one layer having a low refractive index which is lower than 1.55, defined as "LI layer", and at least one layer having a high refractive index which is equal to or higher than 1.55, defined as "HI layer".

According to the invention, this at least one HI layer comprises and preferably consists in silicon nitride (Si₃N₄) that has been deposited by vacuum evaporation of a silicium raw material using electron gun with ion assistance deposition (IAD) including ion gun under nitrogen gas.

As it will be shown in the experimental part below, the Applicant has found that this specific HI layer comprising Si₃N₄ and preferably made of Si₃N₄ deposited with the claimed parameters enables to obtain a thin interferential multilayered coating whose physical thickness is generally equal to or lower than 270 nm and which is able to and/or configured to provide to the optical article (i.e.: especially on the main face(s) of which is/are covered by the multilayer antireflection coating of the invention, such as the front main face):
* an abrasion resistance, measured according to the SRT test defined in the ASTM F735-81 standard (defined above) which is lower than or equal to 2.0, and
* a critical temperature which is higher than or equal to 75°C.

As mentioned above, the optical article according to the invention has excellent mechanical characteristics.

The critical temperature of the article coated according to the invention is higher than or equal to 75°C, more preferably higher than or equal to 80°C, especially higher than or equal to 85°C, and typically higher than or equal to 90°C. As used herein, a "critical temperature of the article coated according to the invention higher than or equal to 75°C" includes the following values (in °C) and/or any intervals comprised between these values: 75; 76; 77; 78; 79; 80; 81; 82; 83; 84; 85; 86; 87; 88; 89; 90; 91; 92; 93; 94; 95; 96; 97; 98; 99; 100; 101; 102; 103; 104; 105; 110, etc.

Also, the invention provides optical articles with a high abrasion according to the SRT test (as defined above) having a SRT value lower than or equal to 2.0 preferably lower than or equal to 1.9, especially lower than or equal to 1.8, especially lower than or equal to 1.7 and typically lower than or equal to 1.6, such as lower than or equal to 1.5. For instance, the SRT value falls within the range from 1.4 to 2.0. According to the invention, a "SRT value lower than or equal to 2.0" includes the following values and/or any intervals comprised between these values: 1.9; 1.8; 1.7; 1.6; 1.5; 1.4; 1.3; 1.2.

In addition, the invention provides optical articles with a high abrasion according to the Bayer test. Generally, the value of the Bayer test is higher than or equal to 7, preferably higher than or equal to 8, typically higher than or equal to 9, such as higher than or equal to 10. For instance, the value of the Bayer test falls within the range from 7 to 12. According to the invention, a "value of the Bayer test higher than or equal to 7" includes the following values and/or any intervals comprised between these values: 7; 8; 9; 10; 11; 12.

Hence, the interferential coating according to the invention exhibits excellent abrasion and heat resistance, while being very thin, more reliable as compared to the AR coating of the prior art and easy to implement.

In addition, the parameters of the deposition step of the at least one HI layer comprising silicon nitride (Si₃N₄) have been selected by the Applicant so as to obtain a layer (*i.e*.: *HI layer comprising silicon nitride (Si₃N₄))* having an optical index, n, at 550 nm, higher than or equal to 1.9, preferably within the range from 1.95 to 2.2, in particular within the range from 2.0 to 2.15 for an absorption coefficient, k, equal to or lower than 2.5*10⁻³ for any wavelengths in the visible region ranging from 380 nm to 780 nm.

As used herein, "an optical index, n, at 550 nm, higher than or equal to 1.9" includes the following values and/or any intervals comprised between these values: 1.9; 1.95; 2.0; 2.05; 2.1; 2.15; 2.2. Also, as used herein, "an absorption coefficient, k, equal to or lower than 2.5*10⁻³ for any wavelengths in the visible region ranging from 380 nm to 780 nm" includes the following values and/or any intervals comprised between these values: 2.0*10⁻³; 1.5*10⁻³; 1.0*10⁻³; 9*10⁻⁴; 8.5*10⁻⁴; 8.0*10⁻⁴; 7.5*10⁻⁴; 7.0*10⁻⁴; 6.5*10⁻⁴; etc.

Hence, the refractive index of this HI layer comprising silicon nitride (Si₃N₄) is high or the highest while having the lowest absorption (lowest absorption coefficient "k" value).

According to a characteristic of the invention, the evaporation rate of the silicium raw material (corresponding to the deposition rate of silicon nitride (Si₃N₄)) thanks to the electron gun is within the range from 0.5 nm/s to 1nm/s and is preferably ranging from 0.7 nm/s to 0.9 nm/s. As used herein, "an evaporation rate of the silicium raw material or a deposition rate of silicon nitride (Si₃N₄) within the range from 0.5 nm/s to 1 nm/s" includes the following values (in nm/s) and/or any intervals comprised between these values: 0.5; 0.55; 0.60; 0.65; 0.70; 0.75; 0.80; 0.85; 0.90; 0.95; 1.0.

According to another characteristic of the invention, the ion gun has an anode current discharge within the range from 3.5 A to 5.5 A, preferably within the range from 4 A to 5 A. As used herein, "an anode current discharge within the range from 3.5 A to 5.5 A" includes the following values (in A) and/or any intervals comprised between these values: 3.5; 3.6; 3.7; 3.8; 3.9; 4.0; 4.1; 4.2; 4.3; 4.4; 4.5; 4.6; 4.7; 4.8; 4.9; 5.

According to another characteristic of the invention, the ion gun has an anode voltage within the range from 80 V to 120 V, preferably from 90 V to 115 V and typically from 100 V to 115 V. Also, according to the invention, "an anode voltage within the range from 80 V to 120 V" includes the following values (in V) and/or any intervals comprised between these values: 80; 85; 90; 95; 100; 105; 110; 115; 120.

In addition, the thin interferential multilayered coating according to the invention enables to improve the optical characteristics of an optical article and has very good performances in the visible domain between 380 to 780 nm, that is to say it enables to strongly reduce the forward reflection in the visible domain.

Generally, the thin interferential multilayered coating has or is able to and/or configured to provide to the optical article a very low mean light reflection factor in the visible region, Rᵥ, and preferably also a low mean reflection factor Rᵤᵥ between 280 nm and 380 nm on the rear main face of the optical article.

Especially, the thin interferential multilayered coating has or the optical article has, on its front main face and/or on its rear main face,
- a mean light reflection factor in the visible region, Rᵥ, defined in the ISO 13666:1988 standard and measured in accordance with the ISO 8980-4: 2006, which is lower than or equal to 2.5%, preferably lower than or equal to 2.0%, especially lower than or equal to 1.5% and typically lower than or equal to 1.0% at an angle of incidence of 15° and/or 35°,
   and/or advantageously,
- a mean reflection factor Rᵤᵥ between 280 nm and 380 nm on the rear main face of the optical article, weighted by the function W(λ) defined in the ISO 13666:1998 standard, lower than or equal to 10%, preferably lower than or equal to 5%, even more preferably lower than or equal to 4% and typically lower than or equal to 3%, for an angle of incidence of 15° and/or 35°, and

Furthermore, the thin interferential multilayered coating according to the invention enables to improve the colorimetric characteristics of an optical article and its robustness.

In general, the thin interferential multilayered coating has in reflection or is able to and/or configured to provide to the optical article a relatively low Chroma C*, a low Chroma standard deviation and a low hue standard deviation.

In particular, the thin interferential multilayered coating has or the optical article has, on its front main face and/or on its rear main face, in reflection, and for an angle of incidence of 15° and/or 35°:
- a Chroma C* defined in the international colorimetric CIE L*a*b* (1976) which is lower than or equal to 15, preferably lower than or equal to 14, especially lower than or equal to 12, typically lower than or equal to 11, such as lower than or equal to 10; and/or
- a Chroma C*, whose standard deviation, defined as "σC", which is lower than or equal to 2.5, preferably lower than or equal to 2.0 and/or
- a hue angle defined in the international colorimetric CIE L*a*b* (1976) whose standard deviation, defined as "σh" (especially for an angle of incidence of 15°), is lower than or equal to 15°, preferably lower than or equal to 12°, typically lower than or equal to 10°, such as lower than or equal to 8°.

The structure of the thin interferential multilayered coating according to the invention will be described hereafter.

As mentioned above, the total physical thickness of the thin interferential multilayered coating according to the invention is generally lower than or equal to 270 nm, preferably lower than or equal to 260 nm, more preferably lower than or equal to 250 nm, especially lower than or equal to 240 nm, and typically lower than or equal to 230 nm. Generally, the total physical thickness of the thin interferential multilayered coating according to the invention is higher than or equal to 140 nm, preferably higher than or equal to 150 nm, in particular higher than or equal to 160 nm and typically higher than or equal to 170 nm. According to an embodiment of the invention, the total physical thickness of the thin interferential multilayered coating according to the invention is within the range from 150 nm to 270 nm, preferably from 160 nm to 260 nm, in particular from 170 nm to 250 nm and typically from 180 nm to 240 nm, such as from 190 nm to 230 nm.

As used herein, a "total physical thickness of the thin interferential multilayered coating according to the invention which is lower than or equal to 270 nm" includes the following values (in nm) and/or any intervals comprised between these values: 270; 260; 250; 240; 230; 220; 210; 205; 200; 195; 190; 185; 180; 170; 160; 150; 140; 130; 120; 110; 100; 95; etc.

Also, according to the invention, the thin interferential multilayered coating according to the invention comprises at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄).

It is here a simple stack, since the layer total number in the interferential coating is higher than or equal to 2 and in general lower than or equal to 6.

According to an aspect of the invention, the total number of HI and LI layers in the multilayered interferential coating is higher than or equal to 3, and preferably higher than or equal to 4.

According to another aspect of the invention, the total number of HI and LI layers in the multilayered interferential coating is lower than or equal to 6, and especially lower than or equal to 5.

For instance, the total number of HI and LI layers in the interferential coating ranges from 4 to 6 layers.

HI layers and LI layers don't need to alternate with each other in the stack, although they also may, according to one embodiment of the invention. Two HI layers (or more) may be deposited onto each other, as well as two LI layers (or more) may be deposited onto each other. In the present application, when two HI layers (or more) are deposited onto each other, they are not considered as being a single HI layer when counting the number of layers of the interferential stack. The same applies to stacks of two or more adjacent LI layers.

In general, the HI layers and LI layers alternate with each other in the stack of the interferential coating according to the invention.

Generally, the at least one HI layer comprising silicon nitride (Si₃N₄), named hereafter "first HI layer comprising silicon nitride" is relatively thick and has a physical thickness higher than or equal to 60 nm, preferably higher than or equal to 70 nm, typically higher than or equal to 80 nm. In particular, the at least one/first HI layer comprising silicon nitride (Si₃N₄) has a physical thickness lower than or equal to 130 nm, preferably lower than or equal to 120 nm. For instance, the at least one HI layer comprising silicon nitride (Si₃N₄) has a physical thickness within the range from 60 nm to 130 nm, preferably from 70 nm to 120 nm and in particular from 75 nm to 110 nm.

In general, this at least one/first HI layer comprising silicon nitride (Si₃N₄) is, in the direction moving away from said substrate, in the last place or in the second last place among all the HI layers of said multilayered interferential coating. In other words, in the direction moving away from said substrate, this at least one/first HI layer comprising silicon nitride (Si₃N₄) is located directly below the outermost layer of the interferential coating, which is generally a LI layer or directly below a thin antistatic layer (such as defined below).

Thus, the at least one/first HI layer comprising silicon nitride (Si₃N₄) is not the innermost layer which is the closest from the base element/substrate among all the HI layer(s) and LI layer(s) composing the at least one multilayered interferential coating.

In general, the at least one multilayered interferential coating comprises, in the direction moving away from the substrate: "another HI layer" which is different from the at least one/first HI layer comprising silicon nitride (Si₃N₄), said "another HI layer" being the innermost layer which is the closest from the base element/substrate among all the HI layers, and preferably among all the HI layers and LI layers composing the at least one multilayered interferential coating.

According to one embodiment of the invention, especially when the optical article does not comprise an underlayer (such as defined below) generally placed between the base element/ substrate and the multilayered interferential coating or between a hardcoat (also named, anti-abrasion and scratch resistant coating) and the multilayered interferential coating, this "another HI layer" (which is the innermost layer among all the HI layers and the LI layers of the multilayered interferential coating) is not a HI layer comprising or composed of Si₃N₄. For instance, according to this embodiment, the innermost layer among all the HI layers and the LI layers of the multilayered interferential coating may be another HI layer (such as defined below) and is preferably a HI layer comprising or composed of ZrO₂.

According to another embodiment of the invention, especially when the optical article comprises an underlayer (such as defined below), the "another HI layer" which is the innermost layer from the base element/substrate among all the HI layers and the LI layers of the multilayered interferential coating is a HI layer (such as defined below), such as comprising ZrO₂, Ta₂O₅, etc. or may be a second layer comprising Si₃N_{4,} . Generally, this innermost layer will be a HI layer comprising and preferably composed of silicon nitride (Si₃N₄), such as for instance a second HI layer comprising silicon nitride (Si₃N₄).

In general (according to the embodiments), said "another HI layer" comprises ZrO₂, more preferably consists in ZrO₂ or can be a second layer comprising or composed of Si₃N₄ (excluded from the first embodiment).

Preferably, this "another HI layer" has in general a physical thickness lower than or equal to 60 nm, preferably lower than or equal to 50 nm, more preferably lower than or equal to 40 nm and typically lower than or equal to 35 nm. Generally, this "another HI layer" has in general a physical thickness higher than or equal to 8 nm, preferably higher than or equal to 10 nm.

In addition, apart from the first HI layer comprising silicon nitride (Si₃N₄), each HI layer of multilayered interferential coating, has in general a physical thickness lower than or equal to 60 nm, preferably lower than or equal to 50 nm, more preferably lower than or equal to 40 nm and typically lower than or equal to 35 nm, and generally, higher than or equal to 8 nm, preferably higher than or equal to 10 nm.

Furthermore, as mentioned above, preferably the outermost layer of the interferential coating is a LI layer. This outermost LI layer may have a thickness higher than or equal to 55 nm, preferably higher than or equal to 60 nm, more preferably higher than or equal to 70 nm. In addition, this outermost LI layer may have a thickness lower than or equal to 105 nm, more preferably lower than or equal to 95 nm and typically lower than or equal to 85 nm.

According to another characteristic of the invention, the at least one multilayered interferential coating comprises, in order starting from the base element/substrate,
(1) an innermost HI layer (named above "the another HI layer" that may be composed for instance of ZrO₂ or Si₃N₄) having a physical thickness lower than or equal to 60 nm, in particular ranging from 8 nm to 50 nm, preferably ranging from 8 nm to 45 nm, and typically ranging from 10 nm to 40 nm, such as ranging from 12 nm to 35 nm;
(2) a LI layer having a physical thickness lower than or equal to 50 nm, in particular ranging from 8 nm to 50 nm, preferably ranging from 8 nm to 45 nm, and typically ranging from 10 nm to 40 nm, such as ranging from 10 nm to 30 nm;
(3) said at least one/first HI layer comprising silicon nitride (Si₃N₄) having a physical thickness higher than or equal to 60 nm, preferably higher than or equal to 70 nm, typically higher than or equal to 80 nm, and especially has a physical thickness within the range from 60 nm to 130 nm, preferably from 70 nm to 120 nm and in particular from 75 nm to 110 nm;
(4) an optional antistatic layer having a physical thickness lower than or equal to 15 nm, in particular ranging from 4 nm to 10 nm;
(5) an outermost LI layer having a physical thickness lower than or equal to 120 nm, in particular ranging from 55 nm to 100 nm, preferably ranging from 60 nm to 95 nm, and typically ranging from 65 nm to 90 nm.

In general, the HI layers are conventional high-refractive-index layers, well known in the art. They generally contain one or more mineral oxides such as, in a non-limiting manner, zirconia (ZrO₂), titanium oxide (TiO₂), trititanium pentoxide (Ti₃O₅), alumina (Al₂O₃), tantalum pentoxide (Ta₂O₅), neodymium oxide (Nd₂O₅), praseodymium oxide (Pr₂O₃), praseodymium titanate (PrTiO₃), La₂O₃, Nb₂O₅, or Y₂O₃. Optionally the high-index layers may also contain silica or other low-refractive-index materials, provided that their refractive index is higher than 1.6 as indicated above. Preferred materials are TiO₂, PrTiO₃, ZrO₂, Ta₂O₅, Al₂O₃, Y₂O₃ and their mixtures. Preferably, the one or more HI layers are made of zirconia (ZrO₂).

The LI layers are also well-known low-refractive-index layers and may comprise, in a non-limiting manner: silicon oxide, or else a mixture of silica and alumina, in particular silica doped with alumina, the latter contributing to increase the thermal resistance of the UV-reflecting interference coating. Each LI layer is preferably a layer comprising at least 80% by weight silica and better still at least 90% by weight silica, relative to the total weight of the layer, and even better still consists of a silica layer (i.e.: not obtained by evaporation of at least one precursor compound, such as SiO₂, using electron-beam evaporation with introduction of oxygen gas in the vacuum chamber).

Optionally, the low-index layers may also contain high-refractive-index materials, provided that the refractive index of the resulting layer is lower than 1.55.

When a LI layer comprising a mixture of SiO₂ and Al₂O₃ is used, it preferably comprises from 1% to 10% by weight, better still from 1% to 8% by weight and even better still from 1% to 5% by weight of Al₂O₃, with respect to the total weight of SiO₂ + Al₂O₃ in this layer. For example, SiO₂ doped with 4% or less Al₂O₃ by weight, or SiO₂ doped with 8% Al₂O₃ may be employed. Commercially available SiO₂ / Al₂O₃ mixtures may be used, such as the LIMA^{®} mixture sold by Umicore Materials AG (refractive index comprised between n = 1.48-1.50 to 550 nm) or the substance L5^{®} sold by Merck KGaA (refractive index n = 1.48 to 500 nm).

The optical article, such as an ophthalmic lens, of the invention may be made antistatic, i.e., such as to not retain and/or develop an appreciable electrostatic charge, by virtue of the incorporation of at least one electrically conductive layer into the stack present on the surface of the ophthalmic lens.

This electrically conductive layer is preferably located between two layers of IF coating and/or is adjacent to a high-refractive-index layer of this IF coating. Preferably, the electrically conductive layer is located immediately under the outermost LI sheet of the IF coating, and ideally forms the penultimate layer of the IF coating, i.e., it is located immediately under the outermost LI sheet of the IF coating according to the invention.

The electrically conductive layer must be sufficiently thin not to decrease the transparency of the UV-reflecting interference coating. The electrically conductive layer is preferably made from an electrically conductive and highly transparent material, generally an optionally doped metal oxide. In this case, its thickness preferably ranges from 1 to 15 nm and more preferably from 1 to 10 nm. The electrically conductive layer preferably comprises an optionally doped metal oxide chosen from indium oxide, tin oxide (SnO₂), zinc oxide and their mixtures. Indium tin oxide (tin-doped indium oxide, In₂O₃:Sn), aluminum-doped zinc oxide (ZnO:Al), indium oxide (In₂O₃), and tin oxide (SnO₂) are preferred. According to one optimal embodiment, the electrically conductive and optically transparent layer is a layer of indium tin oxide (ITO) or a layer of tin oxide (SnO₂).

Generally, the electrically conductive layer contributes, within the stack, but to a limited extent, because of its small thickness, to the obtainment of antireflection properties and forms a high-refractive-index layer in the AR coating (also is considered as a HI layer when counting the number of layers). This is the case for layers made from an electrically conductive and highly transparent material such as layers of ITO.

### B.3) The Sub-layer

In one embodiment of the present invention, the interferential coating may be deposited (generally directly) onto a sub-layer (i.e.: the sub-layer is positioned between the substrate and the interferential coating), also named "underlayer". It should be noted that such sub-layer does not belong to the interferential coating according to the invention. The expression " a sub-layer " is understood to mean a coating of relatively large thickness used with the aim of improving mechanical properties such as the resistance of said coating to abrasion and/or scratches and/or to promote its adhesion to the substrate or to the subjacent coating.

On account of its relatively large thickness, the underlayer generally does not participate in the interference optical activity, in particular in the case where it possesses a refractive index similar to that of the underlying coating (which is generally an anti-abrasion and anti-scratch coating) or that of the substrate when the underlayer is deposited directly on the substrate. Therefore, the underlayer, when it is present, is not considered to form part of the reflecting properties of the IF coating.

The underlayer must be thick enough to increase the resistance of the IF coating to abrasion, but preferably not too thick in order not to absorb light as, depending on the nature of the underlayer, this could significantly decrease the relative transmittance τᵥ. Its thickness is generally smaller than 300 nm and better still 200 nm and is generally larger than 90 nm and better still 100 nm.

The underlayer preferably comprises a layer based on SiO₂, this layer preferably comprising at least 80% by weight silica and better still at least 90% by weight silica relative to the total weight of the layer, and even better still this layer consists of a silica layer. The thickness of this silica-based layer is generally smaller than 300 nm and better still 200 nm and is generally larger than 90 nm and better still 100 nm. According to another embodiment, this SiO₂-based layer is a layer of silica doped with alumina, in proportions such as defined above, and preferably consists of a layer of silica doped with alumina. According to one particular embodiment, the underlayer consists of a layer of SiO₂. It is preferable for the underlayer to be a monolayer.

However, the underlayer may be laminated (i.e.: multilayered sub-layer), in particular when the underlayer and the underlying coating (or the substrate if the underlayer is deposited directly on the substrate) have a non-negligible refractive index difference.

Such a multilayered sub-layer generally comprises, in the direction moving toward the base element/substrate,
- the main layer (described above),
- a layer with a high refractive index (such as ZrO₂ or Si₃N₄ obtained according to the claimed method) having generally a thickness lower than or equal to 20 nm, more preferably lower than or equal to 15 nm and most preferably lower than or equal to 10 nm, such as about 5 +/- 5 nm; such layer with a high refractive index is directly contacting the main layer described above;
- a layer with a low refractive index (such as SiO₂) having generally a thickness lower than or equal to 50 nm, more preferably lower than or equal to 45 nm, such as about 40 nm +/- 5 nm.

Typically, in this instance, the sub-layer comprises, deposited in this order onto the optionally coated substrate, a 25-50 nm-thick Si0₂ layer (such as 40 +/- 5 nm-thick SiO₂ layer), a 5-15 nm -thick ZrO₂ or Ta2O₅ layer or Si₃N₄ obtained according to the claimed method (such as 5-10 nm -thick ZrO₂ or Ta₂O5 layer or Si₃N₄ obtained according to the claimed method and thereafter the sub-layer main layer. For instance, this sublayer is suitable so as to be directly coated with the HI innermost layer composed of silicon nitride Si₃N₄ obtained according to the claimed method parameters.

### B.4) Other functional layers

In some applications, it is preferred that the main surface of the substrate be coated with one or more functional coatings improving its optical and/or mechanical properties, prior to depositing the interferential coating of the invention.

These functional coatings traditionally used in optics may be, without limitation, an impact-resistant primer layer, an internal abrasion-resistant coating (also named hard coat), an antistatic coating especially on the concave face of the optical article, or a stack made of two or more of such coatings. Preferably, the ophthalmic lens comprises no photochromic coating and/or comprises no photochromic substrate.

In general, an optical article such as an ophthalmic lens according to the invention comprises a base element/substrate coated in succession on its front face with an anti-shock primer layer, with an anti-abrasion and/or anti-scratch layer, the interferential coating according to the invention, and optionally with a hydrophobic and/or oleophobic coating. The optical article according to the invention is preferably an ophthalmic lens for a pair of spectacles (spectacle lenses), or an ophthalmic lens blank. The lens may be a polarized lens, a photochromic lens, or a tinted sunglass lens, optionally providing a correction.

In addition, the back face of the optical article such as ophthalmic lens substrate may be coated in succession with an anti-shock primer layer, with an anti-abrasion and/or anti-scratch layer, with the interferential coating according to the invention, and optionally with a hydrophobic and/or oleophobic coating.

In one embodiment, the optical article according to the invention does not absorb in the visible or not much, which means, in the context of the present application, that its transmission factor in the visible range τ_{V}, also called relative transmission factor in the visible range, is higher than 90%, more preferably higher than 95%, even more preferably higher than 96% and most preferably higher than 97%.

The factor τ_{V} should be understood as defined by the international normalized definition (ISO 13666:1998 Standard) and is measured in accordance with the ISO 8980-3 Standard. It is defined in the wavelength range of from 380 to 780 nm.

Preferably, the light absorption of the article coated according to the invention is lower than or equal to 1%.

### B.41 The abrasion-resistant and/or to scratch-resistant coatings

The abrasion-resistant and/or to scratch-resistant coatings are preferably hard coatings based on poly(meth)acrylates or on silanes generally comprising one or more mineral fillers intended to increase the hardness and/or the refractive index of the coating once cured.

Hard anti-abrasion and/or anti-scratch coatings are preferably prepared from compositions comprising at least one alkoxysilane and/or a hydrolyzate of the latter, for example obtained by hydrolysis with a hydrochloric acid solution and optionally condensation and/or curing catalysts.

Mention may be made, among the coatings recommended in the present invention, of coatings based on epoxysilane hydrolyzates, such as those described in the patents FR 2702486 (EP 0614957), US 4 211 823 and US 5 015 523.

A preferred composition for an anti-abrasion and/or anti-scratch coating comprises an epoxytrialkoxysilane and dialkyldialkoxysilane hydrolyzate, colloidal silica and a catalytic amount of aluminum-based curing catalyst, such as aluminum acetylacetonate, the remainder being essentially composed of solvents conventionally used for the formulation of such compositions. Preferably, the hydrolyzate used is a hydrolyzate of y-glycidoxypropyltrimethoxysilane (GLYMO) and dimethyldiethoxysilane (DMDES).

The anti-abrasion and/or anti-scratch coating composition may be deposited on the main surface of the substrate by dip coating or spin coating. It is subsequently cured by the appropriate route (preferably thermal or UV).

The thickness of the anti-abrasion and/or anti-scratch coating generally varies from 2 to 10 µm, preferably from 3 to 5 µm.

### B.42 Primer coating

It is possible, prior to the deposition of the anti-abrasion and/or anti-scratch coating, to deposit, on the substrate, a primer coating which improves the impact resistance and/or the adhesion of the subsequent layers in the final product. This coating can be any impact-resistant primer layer conventionally used for articles made of transparent polymeric material, such as ophthalmic lenses.

Mention may be made, among preferred primer compositions, of compositions based on thermoplastic polyurethanes, such as those described in the Japanese patents JP 63-141001 and JP 63-87223, poly(meth)acrylic primer compositions, such as those described in the patent US 5 015 523, compositions based on thermosetting polyurethanes, such as those described in the patent EP 0 404 111, and compositions based on poly(meth)acrylic latexes or on latexes of polyurethane type, such as those described in the patents US 5 316 791 and EP 0 680 492.

Preferred primer compositions are polyurethane-based compositions and latex-based compositions, in particular polyurethane latexes optionally containing polyester units.

### B.43 Hydrophobic coatings and/or oleophobic coatings

The ophthalmic lens according to the invention may also comprise coatings, formed on the UV-reflecting interference coating and capable of modifying its surface properties, such as hydrophobic coatings and/or oleophobic coatings (anti-smudge topcoat). These coatings are preferably deposited on the external layer of the UV-reflecting interference coating. They are generally less than or equal to 10 nm in thickness, preferably from 1 to 10 nm in thickness and better still from 1 to 5 nm in thickness.

It is generally a question of fluorosilane or fluorosilazane coatings. They may be obtained by depositing a fluorosilane or fluorosilazane precursor preferably comprising at least two hydrolysable groups per molecule. The fluorosilane precursors preferably contain fluoropolyether groups and better still perfluoropolyether groups. These fluorosilanes are well known and are described, *inter alia* in patents US 5,081,192, US 5,763,061, US 6,183, 872, US 5,739, 639, US 5,922,787, US 6,337,235, US 6,277,485 and EP 0933377.

One preferred hydrophobic and/or oleophobic coating composition is sold by Shin-Etsu Chemical under the denomination KP 801 M(R). Another preferred hydrophobic and/or oleophobic coating composition is sold by Daikin Industries under the denomination OPTOOL DSX(R). It is a question of a fluororesin comprising perfluoropropylene groups.

### D) Process

The present invention may also relate to a method for manufacturing an optical article, especially the one described above, comprising the following steps:
- providing a base element having a front main surface and a rear main surface;
- applying by vacuum evaporation on said rear main surface and/or on said front main surface, at least one interferential multilayered coating comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si3N4),
characterized in that said at least one HI layer comprising silicon nitride (Si3N4) has been deposited by vacuum evaporation of a silicium raw material using electron gun with ion assistance deposition (IAD) including an ion gun under nitrogen gas.

The method according to the invention enables to obtain an optical article exhibiting:
* an abrasion resistance, measured according to the SRT test as defined in paragraph "Detailed description, A°) Definition", which is lower than or equal to 2.0,
* a critical temperature which is higher than or equal to 75°C, and
* preferably an optical index, n, higher than or equal to 1.9 at 550 nm for an absorption coefficient, k, equal to or lower than 2.5*10-3 for any wavelengths in the visible region ranging from 380 to 780 nm,
wherein the total physical thickness of the at least one interferential coating is preferably equal to or lower than 270 nm.

The Applicant has found that specific parameters of the claimed method enable to provide an interferential coating exhibiting excellent abrasion and heat resistance and especially enable to get a suitable HI layer comprising silicon nitride having the good compromise between high refractive index and low absorption, while providing an increased yield.

According to a characteristic of the invention, the evaporation rate of the silicium raw material (corresponding to the deposition rate of silicon nitride (Si₃N₄)) thanks to the electron gun is within the range from 0.5 nm/s to 1nm/s and is preferably ranging from 0.7 nm/s to 0.9 nm/s. As used herein, "an evaporation rate of the silicium raw material or a deposition rate of silicon nitride (Si₃N₄) within the range from 0.5 nm/s to 1 nm/s" includes the following values (in nm/s) and/or any intervals comprised between these values: 0.5; 0.55; 0.60; 0.65; 0.70; 0.75; 0.80; 0.85; 0.90; 0.95; 1.0. According to the invention, it is a "programmed rate" considering that the deposited material has a density of 1. This is not an actual rate.

According to another characteristic of the invention, the ion gun has an anode current discharge within the range from 3.5 A to 5.5 A, preferably within the range from 4 A to 5 A. As used herein, "an anode current discharge within the range from 3.5 A to 5.5 A" includes the following values (in A) and/or any intervals comprised between these values: 3.5; 3.6; 3.7; 3.8; 3.9; 4.0; 4.1; 4.2; 4.3; 4.4; 4.5; 4.6; 4.7; 4.8; 4.9; 5.

According to another characteristic of the invention, the ion gun has an anode voltage within the range from 80 V to 120 V, preferably from 90 V to 115 V and typically from 100 V to 115 V. Also, according to the invention, "an anode voltage within the range from 80 V to 120 V" includes the following values (in V) and/or any intervals comprised between these values: 80; 85; 90; 95; 100; 105; 110; 115; 120.

Naturally, the various embodiments described above for the optical article also apply to this method of manufacturing the optical article and will not be repeated below.

The other layers of the interferential coating may be deposited by vapor phase deposition, under vacuum, in a vacuum deposition chamber, according to any of the following methods:
i) by evaporation, optionally under ion beam assistance;
ii) by ion-beam spraying;
iii) by cathode sputtering;
iv) by plasma-assisted chemical vapor deposition.

These various methods are described in the following references "Thin Film Processes" and "Thin Film Processes II," Vossen & Kern, Ed., Academic Press, 1978 and 1991, respectively. A particularly recommended method is evaporation under vacuum. Preferably, the deposition of each of the above-mentioned layers is conducted by evaporation under vacuum. Such a process does advantageously avoid heating the substrate, which is particularly interesting for coating heat-sensitive substrates such as organic glasses.

In general, the different other layers of the interferential coating and the other layers of the optical article are deposited by vacuum evaporation, optionally under ion beam assistance.

By referring to Fig.1, a material deposition device according to one implementation variant that is suitable for manufacturing the optical article according to the invention or for performing the method according to the invention will be described hereafter.

The device of Fig.1 for depositing materials through vacuum evaporation comprises a treating chamber 10 defined by side walls 11, a substrate holder 12 and an ion gun 2. This ion gun 2 comprises an outlet 13 that is able to generate an ion beam 14 directed towards the substrate holder 12 and especially which is able to get N⁺ ions and nitrogen atoms from N² gas which is introduced into the treating chamber 10 during the deposition step for forming the Si₃N₄ layer. This is materialized by the creation of a plasma at the outlet 13 of the ion gun 2 which is diffused throughout the chamber 10. The treating chamber 10 also comprise a material source 15a (typically silicium raw material for forming the silicon nitride layer) that can evaporate through electron bombardment 15c generated by an electron gun 15b. This electron gun 15b is able to bombard with electrons the material source 15a to generate an evaporated material beam 17 directed towards the substrate holder 12. Especially, for the formation of Si₃N₄, the electron bombardment 15c vaporizes silicon which will combined in the chamber 10 or on the substrate holder 12 with nitrogen atoms or N+ ions to form SI₃N_{4.v}.The treating chamber 10 may also comprise a gun cover 18 rotatably movable between a close position a) and an open position b) releasing the ion gun outlet 2.

### E) Eyewear

The invention also relates to an eyewear comprising

an optical article comprising at least one base element having a front main surface and a rear main surface, at least one interferential multilayered coating deposited on the front main surface and/or on the rear main surface of the base element comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si3N4),
preferably a holding structure configured to hold the at least optical article facing a wearer's eye, in general the optical article is an optical lens, especially an ophthalmic lens,
characterized in that said at least HI layer comprising silicon nitride (Si3N4) of the at least one interferential multilayered coating has been deposited by vacuum evaporation of a silicium raw material using electron gun with ion assistance deposition (IAD) including ion gun under nitrogen gas so as to obtain an optical article exhibiting
   * an abrasion resistance, measured according to the SRT test as defined in paragraph "detailed description, A°) Definition", which is lower than or equal to 2.0, and
   * a critical temperature which is higher than or equal to 75°C, and
wherein the total physical thickness of the at least one interferential coating is preferably equal to or lower than 270 nm.

More particularly, the eyewear according to the invention comprises an optical article as defined above, which may include lenses, all ophthalmic devices such as ophthalmic lenses, spectacle glasses, reading glasses, sunglasses, goggles, sport goggles, diving masks, smart eyewear or augmented reality smart glasses, virtual reality headsets, wearable tech glasses, contact lenses such as corrective contact lenses, cosmetic contact lenses, preferably being spectacle glasses (i.e. comprising two ophthalmic lenses fitted on a frame, possibly satisfying a prescription for power correction and/or astigmatism, e.g. a prescription lens having for instance a convex front surface and a concave rear surface).

Naturally, the various embodiments described above for the optical article or for the method described above also apply to this eyewear and will not be repeated below.

### EXAMPLES

### A) Example 1

In the example, different layers of Si₃N₄ having a thickness of 100 nm have been deposited thanks to a deposition device such as illustrated on Fig.1. Especially, the deposition tool was a BAK760 machine equipped with a Canon APT(8kV) electron gun for the evaporation of the oxides, and a (Veeco Mark II) ion gun for the preliminary phase of preparing the surface of the substrate with argon ions (IPC).

Different method parameters were studied by the Applicant: the anode current (la), the anode voltage (Ua) of the ion gun and the speed of evaporation of the silicium raw material (corresponding to the rate of deposition of silicon nitride). These parameters were studied by varying them to determine the impact of each of them (Ua, la and Rate).

The refractive index and the coefficient of absorption (k) have been determined by spectroscopic ellipsometry.

The results are shown on Fig.2 to Fig.5.
Fig.2 shows that by setting the parameters Ua (140V) and Rate (1nm/s), the refractive index (n) and coefficient of absorption(k) increase when anode current decreases.
Fig.3 shows that by setting the parameters la (4A) and Rate (1nm/s), the refractive index (n) and coefficient of absorption (k) increase when anode voltage increases.
Fig.4 shows that by setting the parameters Ua (140V) and la (4A), the refractive index (n) and coefficient of absorption (k) increase when speed of evaporation increases.
Fig.5 shows that it is preferable, so as to get a Si₃N₄ layer with high optical refractive index and no absorption on visible spectrum, to respect the following parameters:
   - high anode current (Ia) (increase the quantity of nitrogen ions) - 4A to 5A;
   - low anode voltage (Ua)(decrease the ion energy) - 120V to 80V, preferably from 100 V to 115V;
   - low speed of evaporation (Rate) - 1 nm/s to 0.5 nm/s.

It has been observed that with a voltage variation between 100V and 115V, it is possible to decrease the refractive index with no absorption on visible spectrum. To obtain the highest refractive index without absorption the set-up of the parameters are preferably as follows: 115 V; 4.5 A; 0.8 nm/s. These specific parameters give an optical index of 2.04 at a 550 nm wavelength. It has also been observed that a too low anode voltage (≤100V) with a too high evaporation speed (≥1nm/sec) decreases the refractive index and increases the absorption.

### B) Example 2

### B.1) Characterization

Optical and colorimetric measurements (in reflection) of the surface of the base element (i.e.: substrate) coated on either its front surface (front face, Cx) or its rear surface (rear face, Cc) with the exemplified interferential multilayered coatings were carried out with a spectrophotometer. They are provided for an angle of incidence (also named hereafter "AOI" or q) of 15° or 35°.

Mean light reflection factor Rv, hue angle h and chroma C* are defined in the international colorimetric CIE (L*, a*, b*) space. S*uv is defined in the international colorimetric CIE (L*, u*, v*) space. They are calculated considering the standard illuminant D65 and the standard observer 10° for h, C* and the standard observer 2° for Rᵥ.

### B.2) Preparation of the optical articles

The ophthalmic lenses employed in the examples comprise an ESSILOR ORMA^{®} lens substrate 30 of 65 mm diameter, of refractive index of 1.50, of -2.00 diopter power and of 1.2 mm thickness, coated on its front and rear main faces successively with a primer layer and an anti-abrasion and anti-scratch coating (hard coat).

The primer coating having a refractive index of 1.6 was formed from a coating composition having a dry extract weight of 20 % and containing a polyurethane latex (U5200 from Alberdingk Boley), a ZrO2 based colloid (SZR-CW from Sakai Chemical Industry), deionized water and Coatosil 77 as a surfactant.

The anti-scratch coating (hard coat) has also a refractive index around 1.6 and is obtained by curing a composition comprising a hydrolyzate of glycol(gamma glycidoxypropyl trimethoxysilane), a composite colloid of TiO₂/ ZrO₂ /SiO₂ (TiO₂ being a major component). The hard coat thickness is around 2.6 micrometers.

The layers of the antireflection coating were deposited either on its front (Cx) and back (Cc) faces (lenses 1 to 6) without heating of the substrates by vacuum evaporation (evaporation source: the electron gun).

Especially, for lenses 1-4 the method comprises a surface activation step with an argon ion beam (1 A, 100 V) for 30s directly on the substrate, a deposition step of a HI layer (ZrO₂) at a rate of 2 nm/s with passive O² at a pressure setpoint at 8*10⁻⁵ mbar, a deposition step of a SiO₂ layer at a rate of 2 nm/s without any added gas, a deposition step of the HI layer comprising Si₃N₄ at an anode voltage of the ion gun at 115V, anode current discharge of the ion gun at 4.5 A and an evaporation rate of the silicium raw material at 0.8 nm/s, a deposition step of a thin electrically conductive layer (ITO) at a rate of 1 nm/s with an oxygen ion assistance (ion gun: 1.2 A, 120 V), a deposition step of a LI layer (SiO₂) at a rate of 3 nm/s.

For lenses 5 and 6, the same conditions were used for forming the different layers (i.e.: SiO₂ layer at a rate of 2 nm/s without any added gas, ZrO₂ layer at a rate of 2nm/s with passive O² at a pressure setpoint at 8*10⁻⁵ mbar, thin electrically conductive layer (ITO) at a rate of 1 nm/s with an oxygen ion assistance (ion gun: 1.2 A, 120 V) and HI layer comprising Si₃N₄ at an anode voltage of the ion gun at 115V, anode current discharge of the ion gun at 4.5 A and an evaporation rate of the silicium raw material at 0.8 nm/s).

The deposition tool was a BAK760 machine equipped with an APT (8kV) electron gun for the evaporation of the oxides, and a (Veeco Mark II) ion gun for the preliminary phase of preparing the surface of the substrate with argon ions (IPC).

The thickness of the layers was controlled by means of a quartz microbalance. The spectral measurements were carried out using a variable-incidence Perkin-Elmer lambda 850 spectrophotometer with a universal reflectance accessory (URA) and/or a variable-incidence reflectance measurement system (Zeiss spectrometer MCS601).

Two comparative assays have also been carried out by the Applicant including the same substrate and conditions as the examples according to the invention except that the antireflective comprises a stack of SiO₂ and ZrO₂.

The deposit conditions of this stack were as follows:
For comparative lens 1 (Comp. 1) the method comprises a surface activation step with an argon ion beam (1 A, 100 V) for 30s directly on the substrate, a deposition step of a HI layer (ZrO₂) at a rate of 2 nm/s with passive O² at a pressure setpoint at 8*10⁻⁵ mbar, a deposition step of a SiO₂ layer at a rate of 2 nm/s without any added gas, a deposition step of a HI layer (ZrO₂) at a rate of 2 nm/s with passive O² at a pressure setpoint at 8*10⁻⁵ mbar, a deposition step of a thin electrically conductive layer (ITO) at a rate of 1 nm/s with an oxygen ion assistance (ion gun: 1.2 A, 120 V), a deposition step of a LI layer (SiO₂) at a rate of 3 nm/s.

For comparative lens 2 (Comp. 2), the same conditions were used for forming the different layers (i.e.: SiO₂ layer at a rate of 2 nm/s without any added gas, ZrO₂ layer at a rate of 2nm/s with passive O² at a pressure setpoint at 8*10⁻⁵ mbar, thin electrically conductive layer (ITO) at a rate of 1 nm/s with an oxygen ion assistance (ion gun: 1.2 A, 120 V).

The deposition tool was a BAK760 machine equipped with an APT (8kV) electron gun for the evaporation of the oxides, and a (Veeco Mark II) ion gun for the preliminary phase of preparing the surface of the substrate with argon ions (IPC).

The thickness of the layers was controlled by means of a quartz microbalance. The spectral measurements were carried out using a variable-incidence Perkin-Elmer lambda 850 spectrophotometer with a universal reflectance accessory (URA) and/or a variable-incidence reflectance measurement system (Zeiss spectrometer MCS601).

The stack of the first comparative assay does not comprise an underlayer and the stack of the second comparative assay comprises an underlayer such as illustrated on Table 3.

### B.3) Tested Lenses and results

### Examples according to the invention

The following structures according to the invention have been exemplified:

**Table 1**

| | | **Lens 1** | **Lens 2** | **Lens 3** | **Lens 4** |
|---|---|---|---|---|---|
| | | ***Substrate + HC*** | | | |
| | Material | ***AR Ex. 1 (Cx)*** | ***AR Ex. 2 (Cc)*** | ***AR Ex. 3 (Cx)*** | ***AR Ex. 4 (Cx)*** |
| L1 | ZrO₂ | 30.19 | 17.87 | 19.73 | 20.07 |
| L2 | SiO₂ | 11.49 | 14.36 | 14.31 | 15.01 |
| L3 | Si₃N₄ | 85.99 | 104.56 | 88.4 | 87.59 |
| L4 | ITO | 6.5 | 6.5 | 6.5 | 6.5 |
| L5 | SiO₂ | 81.24 | 74.72 | 94.5 | 72.6 |
| Total thickness | | 215.41 | 218.01 | 223.44 | 201.77 |

| **Optical characteristic of the coated surface of the lens (Cx side or Cc side)** | | | | | |
|---|---|---|---|---|---|
| Rv _{@15° (%)} | | 0.74 | 0.9 | 0.5 | 0.79 |
| Rv _{@35° (%)} | | 1.07 | 1.29 | - | 1.38 |
| Ruv _{@35° (%)} | | 6.72 | 2.51 | 9.52 | 2.46 |
| **E-SPF** _{@35°} | | 15 | 40 | 11 | 41 |
| **C*** _{@15°} | | 9 | 9 | 12 | 9 |
| **C*** _{@35°} | | 7 | 2.5 | - | 11 |
| **h*** _{@15°} | | 135 | 135 | 260 | 45 |
| **h*** _{@35°°} | | 143 | 147 | - | 34 |
| **σC*** _{@15°°} | | 1.4 | 1.9 | 1.75 | 1.5 |
| **σh** _{@15°°} | | 2.8 | 5.3 | 3.8 | 8.3 |
| **SRT (Hnorm)** | | **1.5** | **-** | **1.5** | **1.5** |
| **Sand Bayer test** | | **8.5** | **-** | **8.5** | **8.5** |
| **CT (°C)** | | **90** | **-** | **90** | **90** |

Table 1 above shows that Lenses 1 to 4 have excellent mechanical resistance, while having good antireflective properties (very low Rᵥ at an angle of incidence of 15° or 35° and preferably a low Rᵤᵥ at an angle of incidence of 35° and a high E-SPF value, which is important when the interferential coating according to the invention is placed on the Cc side of the optical article (to protect the eyes of the wearer)). Especially, Lens 2 shows the E-SPF effect that can have the stacks according to the invention (so on the back side). There are no SRT and/or CT results because the AR stack is placed on the rear main face of the optical article. However, it is estimated that the values of the SRT and the Sand Bayer tests are equivalent to the other examples according to the invention, namely excellent.

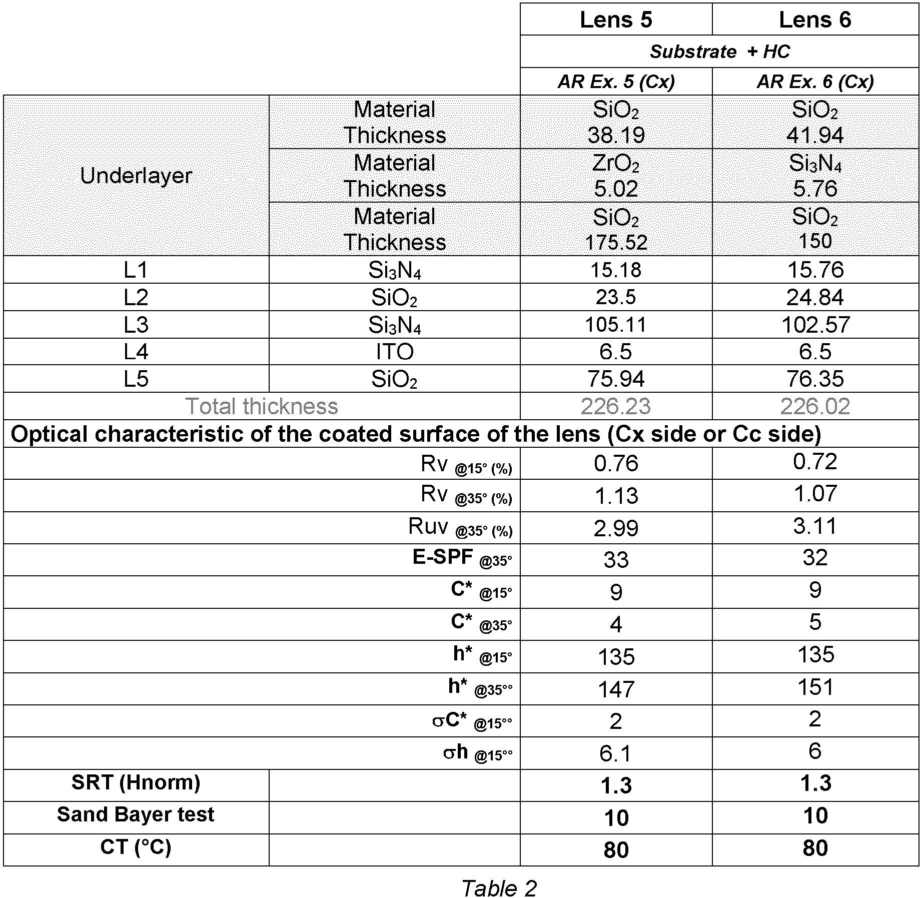

Table 2 above also shows that Lenses 5 and 6 have excellent mechanical resistance, while having good antireflective properties (very low Rᵥ at an angle od incidence of 15° or 35° and preferably a low Rᵤᵥ at an angle od incidence of 35° and a high E-SPF value, which is important to protect the eyes of the wearer).

### Comparative assays (prior art)

The structure and the results of the illustrated lenses (comp.1 and comp.2) according to the prior art were as follows (tables 3 and 4):

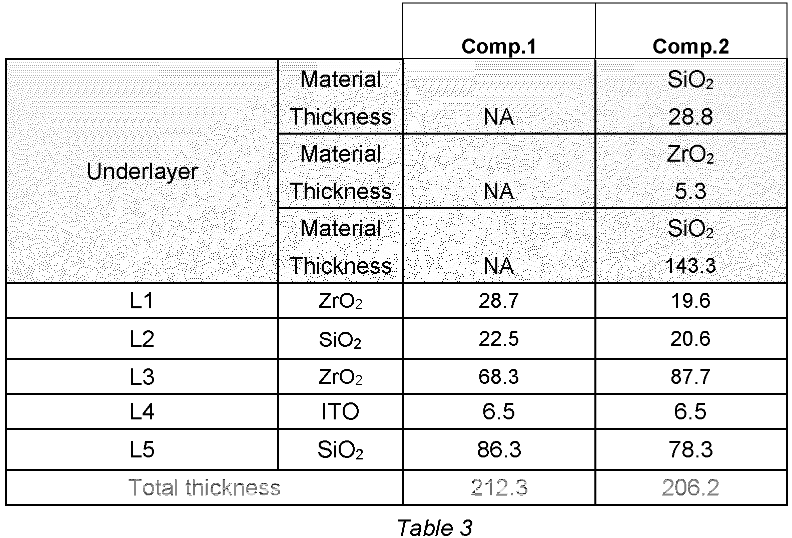

**Table 4**

| **Optical characteristic of the coated surface of the lens (Cx side or Cc side)** | | |
|---|---|---|
| | **Comp.1** | **Comp.2** |
| Rv _{@15° (%)} | 0.75 | 0.69 |
| Rv _{@35° (%)} | 1,.4 | 0.97 |
| Ruv _{@35° (%)} | 2.88 | 1.99 |
| **E-SPF** _{@35°} | 25 | 50 |
| **C*** _{@15°} | 9 | 9 |
| **C*** _{@35°} | 4.4 | 6 |
| **h*** _{@15°} | 135 | 135 |
| **h*** _{@35°°} | 141 | 152 |
| **sC*** _{@15°°} | 1 | 1.7 |
| **sh** _{@15°°} | 3.3 | 5.1 |
| **SRT (Hnorm)** | **2.5** | **2** |
| **Sand Bayer test** | **4** | **5.5** |
| **CT (°C)** | **60** | **50** |

As shown by these tables 3 and 4, these comparative assays present lower abrasion resistance performance when compared with stacks of the invention (i.e.: higher SRT values, lower Bayer values and lower Tc (°C)).

Hence, the structure and the deposit method used for depositing the AR coating according to the prior art do not enable to obtain an optical article having suitable mechanical resistance contrary to the claimed invention.

## Claims

1. Optical article having a front main face and a rear main face, comprising at least:
one base element having a front main surface and a rear main surface,
at least one interferential multilayered coating deposited on the front main surface and/or on the rear main surface of the base element comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
**characterized in that** said at least HI layer comprising silicon nitride (Si₃N₄) has been deposited by vacuum evaporation of a silicium raw material using electron gun with ion assistance deposition (IAD) including ion gun under nitrogen gas so as to obtain an optical article exhibiting
* an abrasion resistance, measured according to the SRT test as defined in paragraph "detailed description, A°) Definition", which is lower than or equal to 2.0, and
* a critical temperature which is higher than or equal to 75°C.

2. Optical article according to claim 1, wherein the abrasion resistance measured according to the SRT test is lower than or equal to 1.9, preferably lower than or equal to 1.8, especially lower than or equal to 1.7 and typically lower than or equal to 1.6.

3. Optical article according to claim 1 or 2, wherein the critical temperature is higher than or equal to 78°C, especially higher than or equal to 80°C and typically higher than or equal to 85°C.

4. Optical article according to any one of the preceding claims, wherein said at least one HI layer comprising silicon nitride (Si₃N₄) has an optical index, n, higher than or equal to 1.9 at 550 nm, preferably has a refractive index at 550 nm ranging from 1.95 to 2.2, in particular ranging from 2.0 to 2.15 for an absorption coefficient, k, equal to or lower than 2.5*10⁻³ for any wavelengths in the visible region ranging from 380 nm to 780 nm.

5. Optical article according to any one of the preceding claims, wherein the total physical thickness of the at least one interferential coating is equal to or lower than 270 nm.

6. Optical article according to any one of the preceding claims, wherein the layer total number in the at least one interferential multilayered coating is
* lower than or equal to 6; and
* preferably is higher than or equal to 3, especially is higher than or equal to 4.

7. Optical article according to any one of the preceding claims, wherein the at least one HI layer comprising silicon nitride (Si₃N₄) is not the innermost layer which is the closest from the base element among all the HI layer(s) and LI layer(s) composing the at least one multilayered interferential coating.

8. Optical article according to any one of the preceding claims, wherein the at least one multilayered interferential coating comprises, in the direction moving away from the substrate: another HI layer which is different from the at least one HI layer comprising silicon nitride (Si₃N₄), said another HI layer being the innermost layer which is the closest from the base element among all the HI layers, and preferably among all the HI layers and LI layers, composing the at least one multilayered interferential coating, in general said another HI layer comprises ZrO₂.

9. Optical article according to any one of the preceding claims, wherein the at least one HI layer comprising silicon nitride (Si₃N₄) has a physical thickness higher than or equal to 60 nm, preferably higher than or equal to 70 nm, typically higher than or equal to 80 nm, and especially has a physical thickness within the range from 60 nm to 130 nm, preferably from 70 nm to 120 nm and in particular from 75 nm to 110 nm.

10. Optical article according to any one of the preceding claims, wherein said optical article has, on its front main face and/or on its rear main face,
- a mean light reflection factor in the visible region, Rᵥ, defined in the ISO 13666:1988 standard and measured in accordance with the ISO 8980-4: 2006, which is lower than or equal to 2.5%, preferably lower than or equal to 2.0%, especially lower than or equal to 1.5% and typically lower than or equal to 1.0% at an angle of incidence of 15° and/or 35°;
and/or
- a mean reflection factor Rᵤᵥ between 280 nm and 380 nm on the rear main face, weighted by the function W(λ) defined in the ISO 13666:1998 standard, lower than or equal to 10%, preferably lower than or equal to 5%, even more preferably lower than or equal to 4% and typically lower than or equal to 3%, for an angle of incidence of 15° and/or 35°.

11. A method for manufacturing an optical article, comprising the following steps:
- providing a base element having a front main surface and a rear main surface;
- applying by vacuum evaporation on said rear main surface and/or on said front main surface, at least one interferential multilayered coating comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
**characterized in that** said at least one HI layer comprising silicon nitride (Si₃N₄) has been deposited by vacuum evaporation of a silicium raw material using electron gun with ion assistance deposition (IAD) including an ion gun under nitrogen gas.

12. The method according to claim 11, wherein the evaporation rate of said silicium raw material thanks to the electron gun is within the range from 0.5 nm/s to 1nm/s and is preferably ranging from 0.7 nm/s to 0.9 nm/s.

13. The method according to claim 11 or 12, wherein the ion gun has an anode current discharge within the range from 3.5 A to 5.5 A, preferably from 4 A to 5 A.

14. The method according to the preceding claims 11 to 13, wherein the ion gun has an anode voltage within the range from 80 V to 120 V, preferably from 90 V to 115 V and typically from 100 V to 115 V.

15. Eyewear comprising:
an optical article having a front main face and a rear main face, comprising at least one base element having a front main surface and a rear main surface, at least one interferential multilayered coating deposited on the front main surface and/or on the rear main surface of the base element comprising at least one layer having a low refractive index which is lower than 1.55, defined as "LI layer", and at least one layer having a high refractive index which is equal to or higher than 1.55, defined as "HI layer", said at least one HI layer comprising silicon nitride (Si₃N₄),
and
preferably a holding structure configured to hold the at least optical article facing a wearer's eye,
**characterized in that** said at least HI layer comprising silicon nitride (Si₃N₄) of the at least one interferential multilayered coating has been deposited by vacuum evaporation of a silicium raw material using electron gun with ion assistance deposition (IAD) including ion gun under nitrogen gas so as to obtain an optical article exhibiting
* an abrasion resistance, measured according to the SRT test as defined in paragraph "detailed description, A°) Definition", which is lower than or equal to 2.0, and
* a critical temperature which is higher than or equal to 75°C.
